# DEMANDE DE BREVET EUROPEEN

(11) **EP 1 282 346 A1**
(43) Date de publication de la demande: **05.02.2003**
(21) Numéro de dépôt: 02291827.0
(22) Date de dépôt: 18.07.2002
(51) Int. Cl.: H05K 5/02, B60R 16/02

(54) **Boîte de sécurité pour composants électriques et électroniques**

(30) Priorité: 31.07.2001 FR 0110273
(71) Demandeur: Valeo Electronique et Systemes de Liaison, 78180 Montigny le Bretonneux (FR)
(72) Inventeur: Basset, Eric, 78960 Voisins le Bretonneux (FR)
(74) Mandataire: Faber, Jean-Paul

(57) **Abrégé**

Boîte de sécurité du type comprenant un corps (1) agencé pour recevoir une série de composants (4) destinés à coopérer avec des organes de connexion insérés sur un circuit électrique (7) relié à une alimentation (9), le corps (9) comportant un couvercle (11) articulé sur le corps (1), caractérisée en ce qu'elle comporte des moyens pour assurer l'ouverture du circuit (7) lorsque la boîte de sécurité est ouverte et la fermeture dudit circuit (7) lorsque la boîte de sécurité est fermée.

## Description

L'invention vise une boîte de sécurité pour composants électriques ou électroniques, tels que relais, fusibles, calculateurs plus particulièrement destinée à être montée sur des véhicules automobiles.

Les véhicules automobiles comportent de plus en plus des équipements électriques et électroniques qui nécessitent des tensions relativement importantes. Il peut, par conséquent, devenir dangereux d'avoir accès directement aux boîtes contenant les fusibles, les relais, les calculateurs, etc.

Le brevet japonais 7 222 330 décrit une boîte de connexion avec un couvercle basculant pourvu d'un doigt destiné, lorsque le couvercle est fermé, à appliquer deux contacts l'un contre l'autre, tandis que lorsque le couvercle est ouvert, le doigt d'effaçant, l'un des contacts élastiquement s'écarte de l'autre. Une telle disposition présente de nombreux inconvénients. Comme, lors de la coupure, il se produit un arc, le contact élastique chauffe et peut perdre de son élasticité de sorte que la coupure risque de ne plus s'effectuer à l'ouverture de la boîte.

L'un des buts de la présente invention est de réaliser une boîte de sécurité remédiant à ces inconvénients.

La boîte de sécurité, selon l'invention, est du type comprenant un corps agencé pour recevoir une série de composants électriques ou électroniques destinés à coopérer avec des organes de connexion insérés sur un circuit électrique relié à une alimentation, le corps comportant, articulé, un couvercle avec des moyens pour assurer l'ouverture du circuit lorsque la boîte de sécurité est ouverte et la fermeture dudit circuit lorsque la boîte de sécurité est fermée, le circuit comportant une coupure avec deux premiers contacts, tandis que le couvercle supporte un premier doigt de contact destiné à s'insérer entre les deux premiers contacts lorsque le couvercle est fermé pour ainsi fermer le circuit électrique, ladite boîte de sécurité étant caractérisée en ce que le circuit comporte une seconde coupure insérée sur une dérivation avec interposition d'une résistance et avec deux seconds contacts, tandis que le couvercle supporte un second doigt de contact, celui-ci étant monté de manière qu'à l'ouverture du couvercle le second doigt de contact échappe les contacts du circuit, après que le premier doigt de contact ait échappé les premiers contacts dudit circuit.

Ainsi, lors de l'ouverture de la boîte de sécurité, les composants sont hors tension et à l'ouverture du couvercle, on limite l'intensité de l'arc électrique qui se forme.

Suivant une caractéristique constructive, le second doigt de contact est monté coulissant dans un support du couvercle contre l'action d'un ressort de rappel de manière que, lors de l'ouverture du couvercle, le second doigt de contact soit maintenu entre les contacts moyennant une compression du ressort de rappel jusqu'à une position angulaire du couvercle dans laquelle le premier contact a déjà échappé les contacts du circuit.

De préférence, le couvercle et le corps ont des moyens de verrouillage conjugués pour assurer le verrouillage automatique du couvercle sur le corps à partir d'une position angulaire déterminée du couvercle. Ainsi, on est assuré que le couvercle sera automatiquement dans sa position de fermeture et qu'ainsi les doigts de contact seront impérativement placés afin de fermer le circuit.

Enfin, suivant une dernière caractéristique constructive, le couvercle comporte, sur sa paroi latérale opposée à celle articulée sur le corps, une patte élastique affectant la forme d'un U avec deux branches et une âme, tandis que le corps, sur sa paroi latérale correspondante est pourvu d'un bossage présentant deux rampes inclinées reliées par un abrupt afin que lorsque l'âme a franchi l'abrupt, l'action conjuguée de l'élasticité de la patte et de la rampe amène le couvercle dans la position de fermeture.

L'invention va maintenant être décrite avec plus de détails en se référant à un mode de réalisation particulier donné à titre d'exemple seulement et représenté aux dessins annexés, dans lesquels :

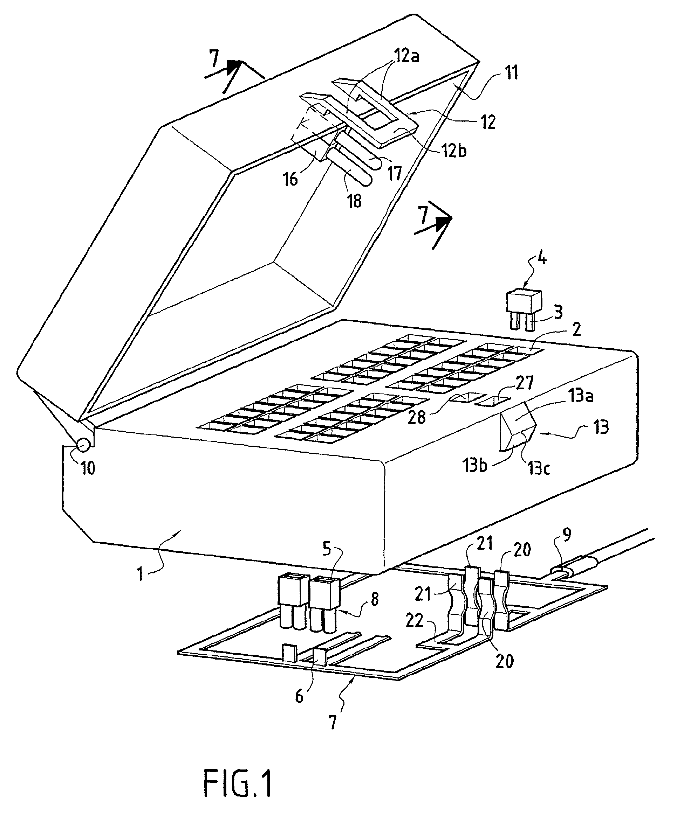

Figure 1 est une vue en perspective d'une boîte de sécurité, selon l'invention.
Figure 2, figure 3 et figure 4 sont des vues schématiques montrant la fermeture de la boîte de sécurité.
Figure 5 et figure 6 montrent les contacts du circuit d'alimentation de la boîte de sécurité.
Figure 7 est une vue en coupe suivant la ligne 7-7 de la figure 1.

La boîte de sécurité représentée aux figures comprend un corps 1 en matière isolante affectant une forme générale parallélépipédique.

Le corps 1 présente une série d'ouvertures 2 à travers lesquelles s'insèrent les branches 3 de fusibles 4 celles-ci coopérant avec des pinces élastiques 5 d'un insert 8 engagé sur des barrettes 6 d'un circuit découpé 7 relié à l'alimentation du véhicule par un conducteur 9.

Le circuit découpé 7 est logé et fixé dans le corps 1 de la boîte de sécurité.

Sur l'une des parois du corps 1 est articulé, sur des charnières 10, un couvercle 11, celui-ci présentant une patte élastique de verrouillage 12 destinée à coopérer avec un bossage 13 de la paroi correspondante du corps 1.

La patte élastique de verrouillage 12 affecte la forme d'un U avec deux ailes 12a et une âme 12b.

Le bossage 13 affecte une forme convexe avec deux rampes inclinées 13a et 13b reliées entre elles par un abrupt 13c.

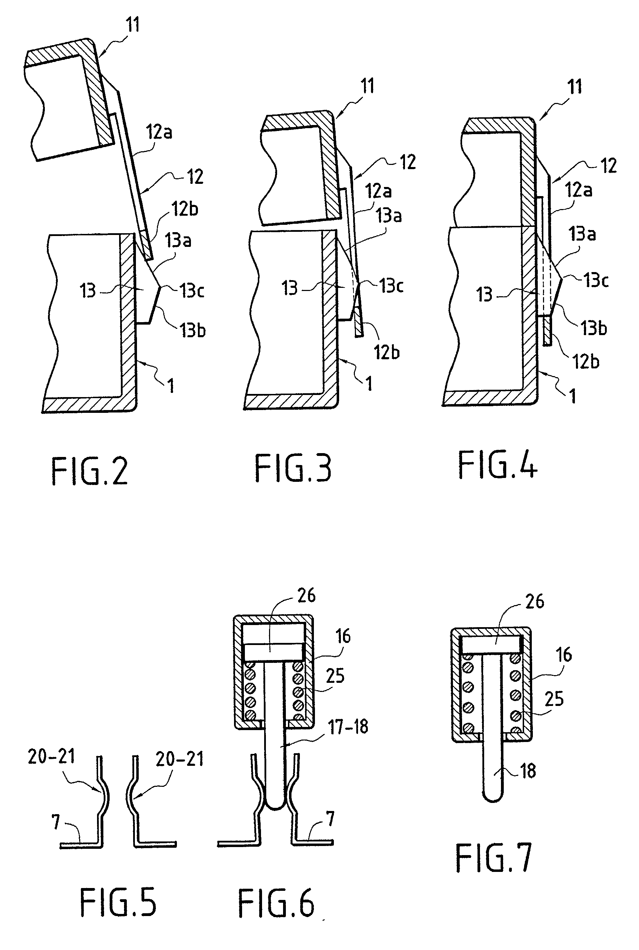

Ainsi, lorsqu'on ferme la boîte de sécurité, l'âme 12b vient porter contre la rampe 12a, la languette 12 se déformant élastiquement jusqu'à ce que l'âme 12b ait franchi l'abrupt 13c. L'effet conjugué de l'élasticité de la languette 12 et de la rampe 13b engendre la fermeture automatique de la boîte de sécurité (voir figures 2, 3 et 4).

On conçoit que, lors de l'ouverture de la boîte de sécurité, lorsque l'âme 12b a dépassé l'abrupt 13c et vient porter contre la rampe 13a, la boîte de sécurité automatiquement s'entrouvre.

Le fond du couvercle 11 comporte un support 16 dans lequel sont montés deux doigts de contact 17 et 18 destinés, lorsque la boîte de sécurité est fermée, à s'insérer dans deux canaux 27 et 28 respectivement du corps 1.

Le circuit découpé 7 présente deux contacts 20 constituant une première coupure du circuit 7 et deux autres contacts 21 constituant une seconde coupure dudit circuit 7, avec interposition d'une résistance 22. Cette dernière pourrait être directement intégrée aux contacts 21.

Pour fermer les différents circuits sur lesquels les fusibles sont insérés, il faut, par conséquent, que les deux coupures soient fermées.

Lorsque la boîte de sécurité est fermée, le premier doigt de contact 17 est inséré entre les contacts 20 et le second doigt de contact 18 entre les contacts 21 de sorte que le circuit 7 est fermé.

Comme on le voit aux figures 6 et 7, le doigt de contact 18 est monté coulissant dans le support 16 contre l'action d'un ressort de rappel 25 monté sur ledit doigt et inséré entre une paroi du support 16 et un épaulement 26.

Ainsi, lors de l'ouverture de la boîte de sécurité, le premier doigt 17 échappe en premier les contacts 20, tandis que le second doigt 18 reste maintenu entre les contacts 20 moyennant la compression du ressort 25 jusqu'à ce que le couvercle occupe une position angulaire dans laquelle ledit doigt 18 échappe les contacts 21, le ressort 25 le ramenant dans sa position initiale.

Une telle disposition permet de diminuer l'intensité de l'arc électrique formé à l'ouverture de la boîte de sécurité.

Bien entendu, l'invention n'est pas limitée au mode de réalisation qui vient d'être décrit et représenté. On pourra y apporter de nombreuses modifications de détail sans sortir pour cela du cadre de l'invention.

## Revendications

1. Boîte de sécurité pour composants électriques et électroniques du type comprenant un corps (1) agencé pour recevoir une série de composants (4) destinés à coopérer avec des organes de connexion insérés sur un circuit électrique (7) relié à une alimentation (9), le corps (1) comportant, articulé, un couvercle (11) avec des moyens pour assurer l'ouverture du circuit (7) lorsque la boîte de sécurité est ouverte et la fermeture dudit circuit (7) lorsque la boîte de sécurité est fermée, ledit circuit (7) comportant une coupure avec deux premiers contacts (20), tandis que le couvercle (11) supporte un premier doigt de contact (17) destiné à s'insérer entre les deux premiers contacts (20) lorsque le couvercle (11) est fermé pour ainsi fermer le circuit électrique, la boîte de sécurité étant **caractérisée en ce que** le circuit (7) comporte une seconde coupure insérée sur une dérivation avec interposition d'une résistance (22) et avec deux seconds contacts (21), tandis que le couvercle supporte un second doigt de contact (18), celui-ci étant monté de manière qu'à l'ouverture du couvercle le second doigt de contact (18) échappe les contacts (21) du circuit après que le premier doigt de contact ait échappé les premiers contacts dudit circuit (7).

2. Boîte de sécurité, selon la revendication 1, **caractérisée en ce que** le second doigt de contact (18) est monté coulissant dans un support (16) du couvercle (11) contre l'action d'un ressort de rappel (25) de manière que, lors de l'ouverture du couvercle, le second doigt de contact soit maintenu entre les contacts moyennant une compression du ressort de rappel (25) jusqu'à une position angulaire du couvercle (11) dans laquelle le premier contact (17) a déjà échappé les contacts (20) du circuit (7).

3. Boîte à de sécurité, selon la revendication 1, **caractérisée en ce que** le couvercle (11) et le corps (1) ont des moyens de verrouillage conjugués pour assurer le verrouillage automatique du couvercle sur le corps à partir d'une position angulaire déterminée du couvercle (11).

4. Boîte de sécurité, selon la revendication 3, **caractérisée en ce que** le couvercle (11) comporte, sur sa paroi latérale opposée à celle articulée sur le corps (1), une patte élastique (12) affectant la forme d'un U avec deux branches (12a) et une âme (12b), tandis que le corps (1), sur sa paroi latérale correspondante, est pourvu d'un bossage (13) présentant deux rampes inclinées (13a, 13b) reliées par un abrupt (13c) afin que, lorsque l'âme (12b) a franchi l'abrupt, l'action conjuguée de l'élasticité de la patte (12) et de la rampe (13b) amène le couvercle dans la position de fermeture.
